# EUROPEAN PATENT APPLICATION

(11) **EP 2 378 664 A1**
(43) Date of publication of application: **19.10.2011**
(21) Application number: 10160065.8
(22) Date of filing: 15.04.2010
(51) Int. Cl.: H03K 19/168, G11C 19/08, G11C 11/16

(54) **Magnetic device**

(71) Applicant: Technische Universität München, 80333 München (DE)
(72) Inventor: Becherer, Markus, 80809 München (DE); Csaba, Gyorgy, Ph.D., 46637 South Bend, Indiana (US); Kiermaier, Josef, 84339 Unterdietfurt (DE); Schmitt-Landsiedel, Doris, Prof., 85521 Ottobrunn (DE); Lugli, Paolo, Prof., 85399 Hallbergmoos (DE)
(74) Representative: Epping - Hermann - Fischer

(57) **Abstract**

A magnetic device is described which comprises a first magnetic layer (1) and at least one second magnetic layer (2) upon each other, wherein the first magnetic layer (1) extends along a main extension direction (99) from a first terminal region (11) to a second terminal region (12), wherein the first terminal region (11) is designed for creating at least one domain wall (10) in the first magnetic layer (1), the domain wall (10) causing a magnetic stray field (3) that extends to the second magnetic layer (2), wherein the at least one second magnetic layer (2) has a plurality of magnetic areas (20), each magnetic area (20) having a respective magnetization, and wherein at least one propagation controlling element (4) controls the propagation of the at least one domain wall (10) from the first terminal region (11) to the second terminal region (12) of the first magnetic layer (1).

## Description

The invention relates to a magnetic device.

In microelectronics, magnetic devices are widely used for information storage. Although there are several promising research device concepts, magnetic devices, however, are not commonly used for logic operations. The main reason for that lies in the difficulty of creating strong and localized magnetic fields in solid-state and thin-film technologies.

Magnetic devices can be controlled by external magnetic fields. Moderate fields can be generated on-chip by electrical wires. This technique is for example known for magnetoelectronic devices as for example magnetoresistive random access memory (MRAM) devices. Although it is known that strong and localized magnetic fields can be created efficiently when using field concentrators as for example a yoke around which a coil is wound, such field concentrators are impossible to realize in planar two-dimensional microelectronic technology. Thus, high currents are required and consequently lots of heat is dissipated as Joule heating.

Although the magnetization can alternatively be influenced directly by spin-polarized currents due to the so called spin-torque effect, the usually required current densities are high as well and therefore can not provide a solution to the problem of efficient magnetic field creation.

So called magnetic field-coupled devices seamlessly integrate logic functionality and non-volatile memory. Such devices usually comprise a plurality of nanomagnets ("magnetic dots") produced in a continuous layer, wherein each of the nanomagnets can interact with its neighbors due to their magnetizations which create magnetic stray fields at the locations of the neighboring nanomagnets.

However, magnetic field-coupled devices also require a strong, local magnetic field and, in particular, a clocking field, for proper operation. Although integrated clocking wires could be used, current densities close to the electromigration limit must flow through the wires in order to generate the required magnetic fields. Resistive losses in the clocking wires will therefore be orders of magnitudes higher than the losses in the magnets themselves caused for instance due to hysteresis losses. Accordingly, the generation of sufficient magnetic fields greatly limits the possibility of using nanomagnets in low-power computer applications. Using spin-torque mechanisms to switch the nanomagnets is not possible as it would require respective electrical contacts to the individual nanomagnets.

It is an object of at least one embodiment to provide a magnetic device which can avoid at least some of the above-mentioned drawbacks in the art.

This object is achieved by means of the subject matter of the independent patent claim. The dependent patent claims, which are hereby explicitly incorporated to the description by reference, relate to advantageous configurations and developments.

According to at least one embodiment, a magnetic device comprises a first magnetic layer and at least one second magnetic layer upon each other. With other words, the first magnetic layer may be arranged upon the at least one second magnetic layer or the at least one second magnetic layer may be arranged upon the first magnetic layer. The first magnetic layer extends along a main extension direction from a first terminal region to a second terminal region, wherein the first terminal region is designed for creating at least one domain wall in the first magnetic layer. The domain wall causes a stray magnetic field that extends to the second magnetic layer, which has a plurality of magnetic areas, each magnetic area having a respective magnetization. Depending on the distance between one or more magnetic areas of the second magnetic layer and the at least one domain wall in the first magnetic layer, the one or more magnetic areas can magnetically couple to each other and interact with the stray magnetic field of the at least one domain wall.

Here and in the following, "magnetic" may preferably denote ferromagnetic properties.

The at least one domain wall is an interface in the first magnetic layer separating at least two different magnetic domains having magnetic moments oriented in different directions. With other words, the domain wall is characterized by a transition between the different magnetic orientations of magnetic moments of the respective magnetic domains, wherein the domain wall represents a finite distance in which the magnetic moments undergo a gradual reorientation from the magnetic orientation of one magnetic domain to the magnetic orientation of another magnetic domain. Preferably, the at least one domain wall separates two magnetic domains having in-plane magnetic orientations in opposite directions, i.e. in each magnetic domain the respective magnetic orientation is directed along the extension plane of the first magnetic layer. The stray magnetic field preferably has a main component which is oriented perpendicularly to first and the second magnetic layer. The particular kind and constitution of the domain wall and, in particular, the magnetic orientation of the magnetic moments in the domain wall and therefore also the stray magnetic field of the domain wall can be for instance controlled by the shape and the geometry of the first magnetic layer.

Due to the first magnetic layer with the at least one domain wall generating a stray magnetic field at the location of the second magnetic layer, disadvantages of known spintronic devices can be avoided which merely use electrical wires to generate the necessary fields and which require large currents generating significant resistive losses.

In particular, the at least one domain wall may propagate in the first magnetic layer so that the first magnetic layer may be formed as a domain wall conductor. Furthermore, the magnetic device comprises at least one propagation controlling element which controls the propagation of the at least one domain wall from the first terminal region to the second terminal region of the first magnetic layer. With other words, the position and propagation of the stray magnetic field of the at least one domain wall along the main extension direction with respect to the second magnetic layer and, in particular, the magnetic areas of the second magnetic layer can be effectively controlled.

Preferably, the first magnetic layer may comprise at least one region which is formed as a magnetic wire extending along the main extension direction. In particular, the magnetic layer may be formed as a magnetic wire or may even comprise a plurality of magnetic wires extending along the main extension direction, wherein the plurality of magnetic wires is arranged transversely to the main extension direction. A magnetic wire may denote a magnetic material which is formed with a shape similar to a wire and which, in particular, has a length that is greater than a width and a height. Such magnetic wire may act similar to a bar magnet, i.e. the individual magnetic moments of the magnetic material of the first magnetic layer preferably orient along, i.e. parallel or anti-parallel to, the main extension direction. The orientation of the magnetic moments in the at least one domain wall and, with other words, the constitution of the domain wall can be controlled by the width and the height of the wire-shaped first magnetic layer which may be constant in a middle portion of the first magnetic layer between the first and second terminal region. The width and/or the height of first terminal region may be greater than the width and/or height of the middle portion, whereas the width and/or height of the second terminal region may be smaller than the width and/or height of the middle portion. Such structure of the first magnetic layer can favor the creation of the at least one domain wall in the first terminal region and the propagation of the at least one domain wall along the main extension direction toward the second terminal region.

In order to control the propagation of the at least one domain wall, the at least one propagation controlling element may comprise a magnetic field generator for generating a magnetic field along the main extension direction of the first magnetic layer. The magnetic field generator may for example comprise one or more coils. The magnetic field provided by the propagation controlling element may induce a reorientation of the magnetic moments of the material of the first magnetic layer resulting in a propagation of the at least one domain wall.

Alternatively or additionally, the propagation controlling element may comprise a current injector which injects an electrical current in the first magnetic layer. The electrical current may be injected spin-polarized or may be spin-polarized by the first magnetic layer, which is preferably ferromagnetic. Since the magnetic moments of the electrons of the electrical current can interact with the magnetic moments of the material of the first magnetic layer, a spin polarization of the electrical current leads to the so called spin-torque effect, i.e. a reorientation of the magnetic moments of the material of the first magnetic layer resulting in a propagation of the at least one domain wall.

Furthermore, the at least one propagation controlling element may comprise at least one domain wall pinning element. Such domain wall pinning element may locally "harden" the magnetic material so that the domain wall, propagating due to a magnetic field and/or an electrical current of certain strength provided by the propagation controlling element, is trapped by the pinning element, requiring an increase of the applied magnetic field and/or the electrical current in order to release and to further propagate the domain wall. The pinning element may comprise one or more notches in the first magnetic layer and/or one or more single domain dots arranged besides the first magnetic layer and/or perpendicularly placed domain wall conductors above the first magnetic layer or in the same plane as the first magnetic layer, which can be used to control the propagation and/or the constitution of the at least one domain wall.

By providing pinning elements and/or by timely varying the strength of the applied magnetic field and/or the applied electrical current, for example in discrete pulses, ramps, square signals and/or sinusoidal signals, the propagation controlling element may provide a non-continuous propagation of the at least one domain wall so that the stray magnetic field propagates along the main extension direction also in a non-continuous, for example step-like, way and thus may serve a clocking magnetic field.

The first magnetic layer may comprise a soft-magnetic material. A soft-magnetic material is a ferromagnetic material which has a small hysteresis curve and can be magnetized and/or changed in the magnetization direction by means of low or moderate magnetic fields, i.e. magnetic fields of less than about 10 mT and preferably of less than 5 mT. Accordingly, a hard-magnetic material has a broad hysteresis curve and can be magnetized and/or changed in its magnetization direction by means of magnetic fields of equal to or more than about 10 mT, preferably of more than 100 mT or even more than several 100 mT.

In a preferred embodiment, the first magnetic layer comprises permalloy or is made of permalloy, which is an alloy mainly comprising Ni and Fe.

The second magnetic layer may comprise a hard-magnetic material having a magnetic anisotropy, i.e. a hard-magnetic material which will align its magnetization to an easy axis. The easy axis of a magnetically anisotropic material is known to a person skilled in the art and denotes an energetically favorable direction of the spontaneous magnetization in the material, wherein the two opposite directions along the easy axis are usually equivalent so that the actual direction of the magnetization can be either of them. The two opposite directions along the easy axis may represent two logic states of the magnetic areas, which can be denoted for example as "up" and "down" or as "1" and "0" states.

In particular, the plurality of magnetic areas of the at least one second magnetic layer or of the plurality of second magnetic layers may form at least one magnetic logic gate and/or a binary memory.

In a preferred embodiment, the second magnetic layer comprises a plurality of alternatively stacked first and second sublayers of Co and Pt, of Co and Pd or of Co and Au.

Furthermore, the magnetic device may comprise a plurality of second magnetic layers stacked upon each other, allowing a three-dimensional structure of the magnetic areas of the second magnetic layers and therefore a very compact device.

The magnetic device described herein may provide a mainstream application, which may even compete with end of the roadmap CMOS ("complementary metal oxide semiconductor") devices in its performance figures, for example regarding speed, energy dissipation, price and/or integration density. The fact that the magnetic areas interact via their stray fields makes wired interconnections obsolete, wherein all logic functionality can be performed by a single second magnetic layer or a plurality thereof. Furthermore, if the magnetic devices described herein lose power, they preserve their state and can be instantly powered up afterwards. They may be moreover radiation-hard and may tolerate arbitrarily low temperatures up to medium high temperatures of about 500 K. In contrast to conventional magnetic devices, the magnetic devices described herein are preferably suitable for applications where low power consumption, robust operation and non-volatility are required. Due to the possibility of clocking the operation of the magnetic devices, they may even be suitable to replace CMOS circuits in memory intensive, low power, medium speed applications. The relative simple technology and the lack of wired interconnections can enable a stacked fabrication resulting in three-dimensional magnetic devices. For example for CMOS devices, such three-dimensional integration is impossible due to the technology and the high dissipation.

Further features, advantages and expediencies will become apparent from the following description of exemplary embodiments in conjunction with the figures.
Figure 1 shows a schematic view of a magnetic device according to an embodiment.
Figure 2 shows a schematic view of a stray magnetic field of a magnetic device according to another embodiment.
Figure 3 shows a schematic view of a magnetic device according to another embodiment.
Figure 4 shows a schematic view of a magnetic device according to another embodiment.
Figure 5 shows a schematic view of a second magnetic layer according to another embodiment.

Components that are identical, of identical type and/or act identically are provided with identical reference symbols in the figures.

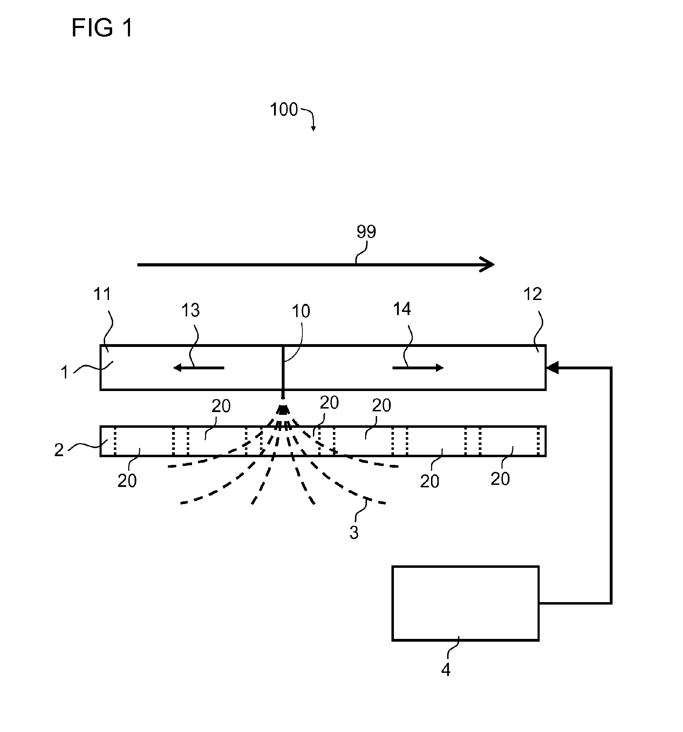

In Figure 1 a magnetic device 100 according to an embodiment is shown. The magnetic device 100 comprises a first magnetic layer 1 and a second magnetic layer 2, wherein the first magnetic layer 1 is situated upon the second magnetic layer 2. Alternatively, the first magnetic layer 1 may be arranged below the second magnetic layer 2. A non-magnetic and/or electrically isolating interlayer (not shown) may be located between the first and second magnetic layers 1, 2 so that the first and second magnetic layer 1, 2 can be stacked on top of each other resulting in a magnetic device that can be formed as an integrated device.

The first magnetic layer 1 extends from a first terminal region 11 to a second terminal region 12 along a main extension direction, which is denoted by arrow 99. The first magnetic layer 1 is made of a soft-magnetic material, which is permalloy in the particular embodiment of Figure 1. Thus, the first magnetic layer comprises magnetic moments which can be oriented in one or more directions resulting in one or more magnetizations. In the exemplary embodiment shown in Figure 1, the first magnetic layer 1 mainly comprises two magnetic domains of magnetic moments having opposite directions as depicted by arrows 13 and 14.

A domain wall 10 separates the two magnetic domains with magnetizations 13 and 14 as described above in the general part. The domain wall 10 causes a stray magnetic field 3 that is schematically shown in part in Figure 1. The stray magnetic field 3 extends to the second magnetic layer 2 so that the second magnetic layer 2 can interact with the stray magnetic field 3 as described in detail below.

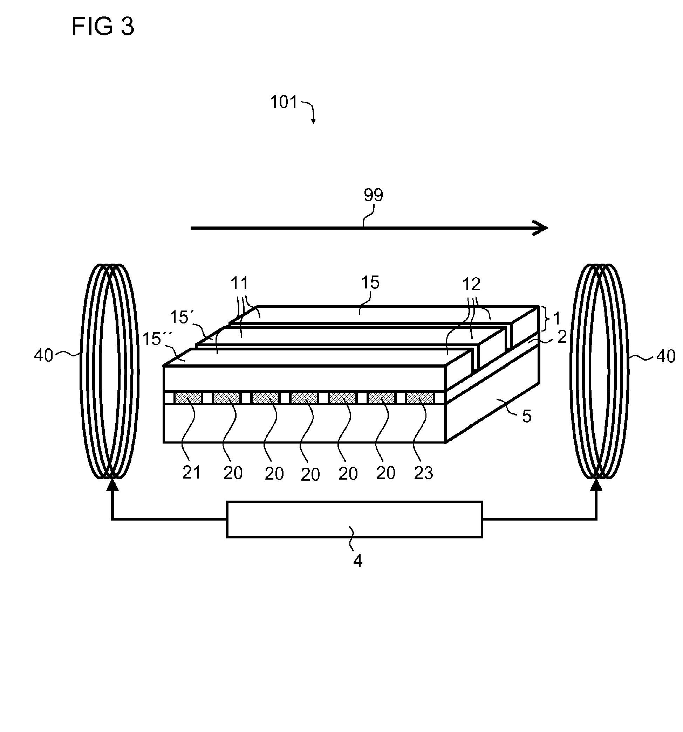

The first terminal region 11 is designed for creating domain walls as the at least one domain wall 10 in the first magnetic layer 1, which can propagate through the first magnetic layer 1 along the main extension direction 99. For example, the first magnetic layer 1 can be formed as magnetic wire having a length along the main extension direction 99 which is greater than a height and a width transversely to the main extension direction 99, wherein the first terminal region 11 has a greater width and/or height than a middle portion of the first magnetic layer 1 between the first and second terminal region 11, 12 and wherein the middle portion has a greater width and/or height than the second terminal region 12, as explained in greater detail below in connection with Figure 3.

The magnetic device 100 further comprises a propagation controlling element 4 for controlling the propagation of the at least one domain wall 10 from the first terminal region 11 to the second terminal region 12 along the main extension direction 99 of the first magnetic layer 1, which is indicated by the arrow reaching from the propagation controlling element 4 to the first magnetic layer 1. The propagation of the at least one domain wall 10 results from a reorientation of the magnetic moments in the two magnetic domains, which is done in a controlled manner for example by applying a magnetic field parallel or anti-parallel to the main extension direction 99 of the first magnetic layer 1. In the embodiment shown in Figure 1 a magnetic field oriented anti-parallel to the main extension direction 99 is suitable to reorient the magnetic moments from the magnetization 14 to the magnetization 13 so that the domain wall 10 effectively propagates toward the second terminal region 12.

Since the first magnetic layer 1 is made of a soft-magnetic material, a relatively low magnetic field strength of about 5 mT or less and preferably of about 2 to 3 mT is sufficient to propagate the at least one domain wall 10. Such magnetic field, preferably a homogeneous or slowly varying magnetic field, can be provided by the propagation controlling element 4, which may have for example a pair of coils generating a magnetic field along the main extension direction 99. Once the at least one domain wall 10 has propagated from the first terminal region 11 to the second terminal region 12, the magnetic field provided by the propagation controlling element 4 can be turned by 180°, i.e. from parallel to anti-parallel or vice versa with respect to the main extension direction 99, so that the formation of a further domain wall 10 may be initiated in the first terminal region 11, wherein the further domain wall 10 also propagates toward the second terminal region 12.

Alternatively, an electrical current can be applied to the first magnetic layer 1, which is spin-polarized by the magnetic material of the first magnetic material and which can interact with the magnetic moments of the first magnetic layer 1 by the so-called spin-torque effect.

The second magnetic layer 2 comprises a plurality of alternatively stacked first and second sublayers of Co and Pt, of Co and Pd or of Co and Au. Each of the sublayers has a thickness of less than 1 nm and the stack comprises at least one Co layer between two layers made of Pt, Pd or Au. Alternatively, the stack may comprise for example about 5 to 40 sublayer pairs so that the thickness of the second magnetic layer 2 is about a few nanometers. The stack of first and second sublayers results in a high magnetic anisotropy with an easy axis oriented perpendicularly to the second magnetic layer 2. The second magnetic layer 2 is patterned to comprise a plurality of magnetic areas 20, wherein each of the magnetic areas 20 has a respective magnetization. Such patterning can be achieved for example by irradiation of the second magnetic layer 2 by a focussed Gaion beam, which can reduce the magnetic anisotropy and therefore can write artificial domain walls between the magnetic areas 20. The magnetic areas 20 have a surface area of equal to or greater than 50 nm by 50 nm and equal to or smaller than 1 µm by 1 µm, wherein the artificial domain walls in-between can have widths of as small as about 30 nm.

Since the easy axis of the Co/Pt-multilayer system of the second magnetic layer 2 is oriented perpendicularly to the extension plane of the second magnetic layer 2, the respective magnetization of each of the magnetic areas 20 can be oriented toward or away from the first magnetic layer 1, representing the logical states "up" and "down" or "1" and "0". The domain wall 10 propagated for example by a weak magnetic field along the main extension direction 99 generates strong stray magnetic field components both in the direction along and perpendicularly to the main extension direction 99, wherein the second magnetic layer 2 is far more sensitive to perpendicular stray field component because of the direction of the out-of-plane easy axis.

Each of the magnetic areas 20 can couple strongly to its nearest neighbors due to the stray magnetic field caused by the respective magnetizations so that under the influence of the stray magnetic field 3 caused by the domain wall 10 the magnetization of a magnetic area 20 may tend to minimize its energy and orient in up or down direction depending on its nearest neighboring magnetic area or areas. Since the magnetic areas 20 are very thin, the stray magnetic field 3 can interfuse the entire volume of a magnetic area. However, the magnetic areas 20 do not strongly perturb the domain wall 10 in the first magnetic layer 1.

The magnetic device may further comprise an additional magnetic element (not shown), for example a permanent magnet, providing a bias magnetic field along the easy axis of the second magnetic layer 2 so that a constant magnetic field can be superposed to the stray magnetic field 3 generated by the at least one domain wall 10.

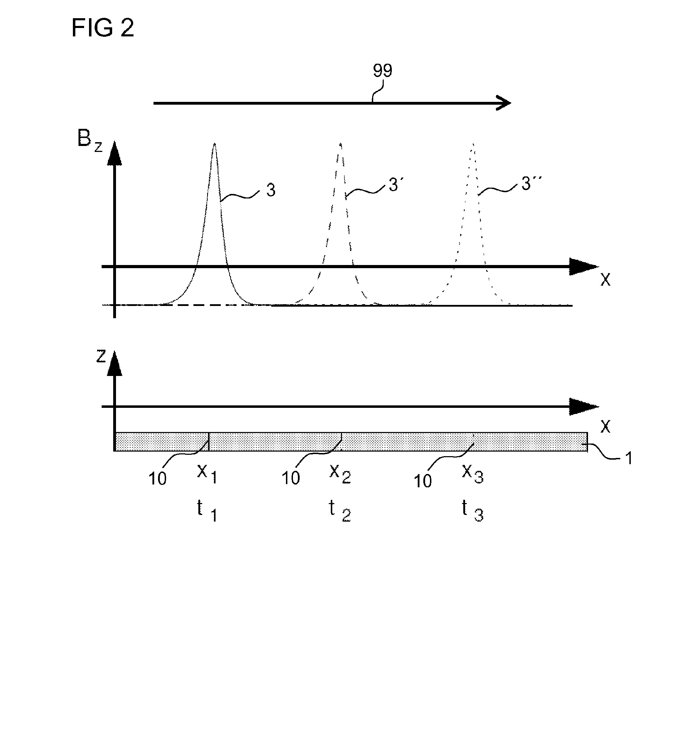

In Figure 2, the stray magnetic field 3, 3' 3" and, in particular, its magnetic field component perpendicular to the first and second magnetic layer 1, 2 at a distance of a few Nanometers, typically about 5 to 10 nm, below the first magnetic layer 1 is schematically shown in arbitrary units at three different positions x₁, x₂ and x₃ along the main extension direction 99 of the first magnetic layer 1, corresponding to three different times t₁, t₂ and t₃ during the propagation of the domain wall 10. The distance of 5 to 10 nm corresponds to a typical distance between the first and second magnetic layers 1, 2 so that Figure 2 shows a typical stray magnetic field 3, 3', 3" at the position of the second magnetic layer 2.

The shown magnetic field component of the stray magnetic field 3, 3', 3" may peak as high as at about 150 mT, which was also confirmed by numerical simulations. Such stray magnetic field is higher than the typical switching field of hard-magnetic materials used in spintronic devices and which, in particular, is higher than the switching field of the second magnetic layer 2 of the embodiment shown herein. The shape and, in particular, the strength and the gradient, of the stray magnetic field 3, 3', 3" at the position of the domain wall 10 remains approximately the same during the domain wall's propagation, providing a predictable propagating magnetic field wave, which can even be used as a magnetic clocking field. In particular, the first magnetic layer 1 may provide a propagating stray magnetic field which has a strength of at least a few ten Millitesla and a field gradient of at least a few ten Millitesla per 100 nm in order to switch the magnetic areas of the second magnetic layer, providing an unidirectional operation along the main extension direction 99.

The speed of the domain wall propagation can be controlled by the propagation controlling element 4, for example by controlling the strength of the magnetic field applied along the main extension direction 99 or the strength of an electrical current applied to the first magnetic layer 1. Preferably, the speed of the domain wall propagation is adapted so that the stray magnetic field spends a time of about 1 ns up to several 10 ns at the position of a magnetic area 20 of the second magnetic layer 2, which is sufficient for the magnetic area 20 to interact with its nearest neighbor or neighbors and to relax into an energetically favorable state which may lead to a reversal of the magnetic area's magnetization.

Thus, the magnetic device 100 described herein provides an on-chip method to use a relatively weak, homogeneous magnetic field of only a few Millitesla, or an electrical current, for creating a strong and localized stray magnetic field wave of up to 100 mT or even more. The propagating stray magnetic field 3 created this way may control the magnetization dynamics of the magnetic areas 20 of the second magnetic layer 2 acting as spintronic device and may deliver energy to it.

In Figure 3 a magnetic device 101 according to a further embodiment is shown, which is a variant of the embodiment shown in Figure 1.

The magnetic device 101 comprises a non-magnetic substrate carrying the first magnetic layer 1 on top of the second magnetic layer 2. Between the first and second magnetic layer 1, 2 a non-magnetic interlayer is situated (not shown) so that the magnetic device 101 with the first and second magnetic layers 1, 2 is formed integrally as a chip-like device.

The first magnetic layer 1 is formed as a plurality of magnetic wires 15, 15', 15" which are arranged transversely to the main extension direction 99 of the first magnetic layer 1 and which extend on top of the second magnetic layer 2 along the main extension direction 99. In a middle portion between the first and second terminal region 11, 12, the magnetic wires 15, 15', 15" have a width of about preferably equal to or greater than 100 nm and equal to or smaller than 300 nm and a height of about equal to or greater than 5 nm and equal to or smaller than 50 nm, preferably equal to or smaller than 25 nm, and a length of more than 1 µm and preferably more than 10 µm and up to 100 µm or even up to 200 µm. For creating domain walls in the magnetic wires 15, 15', 15" , each of the magnetic wires 15, 15', 15" has a first terminal region 11 which has a width and/or height which is greater than the width and/or height in the middle portion (not shown) and a width and/or height in the second terminal region 12 which is smaller than the width and/or height in the middle portion (not shown) so that domain walls are preferably formed in the first terminal region 11.

The domain walls in each of the magnetic wires 15, 15', 15" are simultaneously created and propagated by the propagation controlling element 4, which comprises a magnetic field generator 40 in the form of microcoils. The microcoils are suitable to generate a weak magnetic field along, i.e. parallel or anti-parallel to, the main extension direction 99, which is sufficient to reorient magnetic moments in the first magnetic layer 1 and therefore to propagate the domain walls in the magnetic wires 15, 15', 15". The microcoils may be formed as external elements in the form of inductor-like structures close to the first magnetic layer 1, or may alternatively be formed integrally for example within the substrate 5. In case that the propagation of the domain walls is performed by applying an electrical current to the magnetic wires, the microcoils can even be omitted.

The magnetic device 101 further comprises an electrical input in the form of an induction wire at the first terminal region 11 (not shown) in order to set the magnetization of at least one input magnetic area 21 at the first terminal region 11 so that only in the first terminal region 11 localized magnetic fields have to be generated by electrical currents. Further, the magnetic device 101 comprises an electrical output in form of a magnetic sensor (not shown), for example a Hall-effect sensor, a tunnel magnetoresistance sensor or a giant magnetoresistance sensor, at the second terminal region 12 in order to read the magnetization of at least one output magnetic area 23.

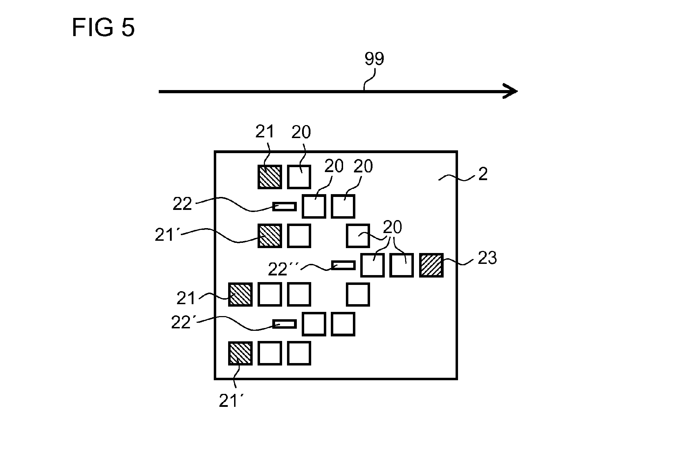

The magnetic device 101 may form a binary memory, for example a shift register or a so-called first-in first-out (FIFO) memory, or a magnetic logic gate, for example an AND, OR, XOR, NAND, NOR, XNOR or NOT logic gate or any combination thereof. An example of an XOR logic gate is shown below in connection with Figure 5.

The possibility to switch the magnetization of the magnetic areas 20 of the second magnetic layer 2 at nanosecond speed results in an operational bandwidth of the magnetic device of up to Megahertz frequencies or even up to Gigahertz frequencies. Since there is no static power dissipation and the dynamic power dissipation in the magnetic areas of the second magnetic layer 2 is very low and typically only a few ten kT per logic operation, the disadvantage of conventional magnetic devices which waste a vast majority of power as Joule heating in magnetic field generating wires can be avoided.

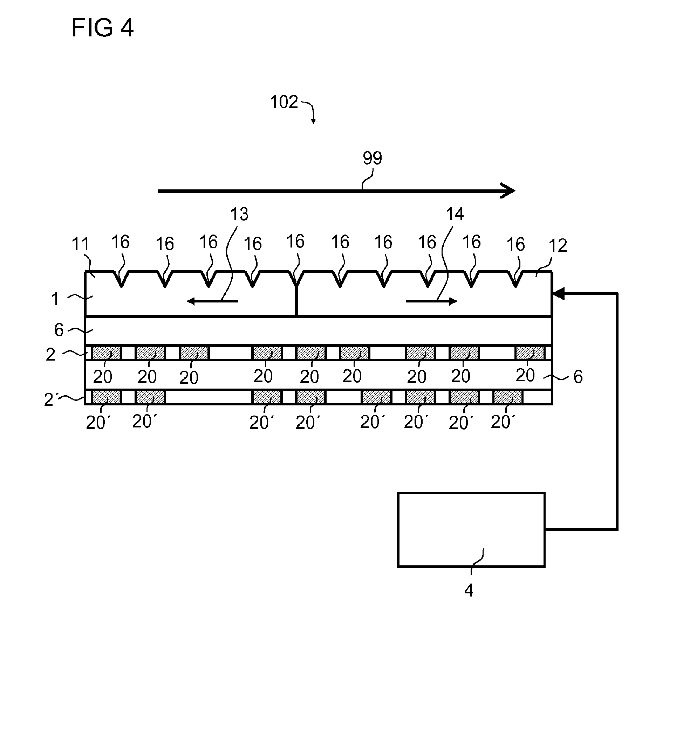

In Figure 4 a magnetic device 102 according to a further embodiment is shown, which is a further variant of the embodiments described above.

The magnetic device 102 comprises a stack of two second magnetic layers 2, 2'. The second magnetic layers 2, 2' have magnetic areas 20 and 20', respectively, which are exemplarily formed in different arrangements so that the second magnetic layers 2, 2' can simultaneously perform different logic or memory operations. The first magnetic layer 1 and the second magnetic layers 2, 2' are separated by respective non-magnetic interlayers 6. The magnetic device 102 may comprise even more second magnetic layers since the stray magnetic field caused by the at least one domain wall 10 can penetrate layers about 100 nm below and above the first magnetic layer 1. For example, the magnetic device 102 can comprise up to 5 or even up to 10 second magnetic layers.

The magnetic device 102 further comprises a propagation controlling element 4 as described in connection with the foregoing embodiments, which further comprises a plurality of domain wall pinning elements 16. The domain wall pinning elements 16 of the particular embodiment are formed as notches in the first magnetic layer 1 which locally harden the magnetic material of the first magnetic layer 1 so that, compared to the regions between the notches, in close proximity of the notches a higher magnetic field, or a higher electrical current, has to be applied by the propagation controlling element 4 in order to release the trapped domain wall 10 and to propagate it to the next notch. For example by applying a magnetic field with a pulsed, ramped, square-wave like or sinusoidal-wave like time dependency along the main extension direction 99, a non-continuous propagation of the at least one domain wall 10 can be performed so that the stray magnetic field caused by the domain wall 10 can act as a clocking field. Such clocking field is advantageous for synchronizing for instance logic operations performed by the second magnetic layers 2, 2'.

Alternatively or additionally to the notches 16, the propagation controlling element 4 can comprise other elements and/or structures which locally harden the magnetic material of the first magnetic layer 1. Such structures, which are described also above in the general part, can for example comprise domain wall propagation structures and/or permalloy structures which are positioned in close proximity to the first magnetic layer 1 and which can be used to trap and release domain walls 10 in a controlled manner. Complicated external control circuitry as required in conventional magnetic devices can therefore be avoided.

In Figure 5, an exemplary embodiment of a second magnetic layer 2 is shown which forms an XOR logic gate and which can be implemented in any of the foregoing embodiments of magnetic devices.

The logic gate comprises input magnetic dots 21, to which an input state A can be applied by orienting the magnetization of the input magnetic areas 21 in either up or down direction, corresponding to the logic states "1" or "0". Similarly, an input state B can be applied to magnetic areas 21'. The magnetization of an output magnetic area 23 corresponds to the output state C = XOR(A,B). For simplicity, Figure 5 does not show input inductors and an output sensor for applying input signals to the input magnetic areas 21, 21' and for reading out the magnetization of the output magnetic area 23, respectively.

The logic gate can be programmed to perform the XOR function by applying a suitable respective magnetization to bias dots 22, 22', 22", which are magnetically harder than the magnetic areas 20, 21, 21', 23 and which do not change their magnetization under the influence of the stray magnetic field of the first magnetic layer. All computing dots, i.e. the magnetic areas 20, 21, 21', 23, have a size of 200 nm by 200 nm and are separated by 20 nm wide gaps. The bias magnetic areas 22 have a size of 200 nm by 100 nm. Alternatively, the magnetic areas 20, 21, 21', 22 ,23 may have sizes below 100 nm by 100 nm, wherein the down-scaling may be limited at least for room temperature operation by the so-called superparamagnetic limit around 30 nm to 50 nm for the length of a magnetic area.

The propagating stray magnetic field of the first magnetic layer 1 "shakes down" the magnetic areas 20 and 23 to their energetic ground state, corresponding to their computational ground state, wherein the signal flow follows the main extension direction 99. Signals can travel transversely to the main extension direction 99 as well, if the magnetic areas 20 halfway overlap with previous magnetic areas in transversal direction. Simulations show that the XOR gate can be demagnetized to its computational ground state for all possible input combinations.

The magnetic device according to the embodiments described herein can effectively create on-chip switching magnetic fields in form of the stray magnetic fields of propagation domain walls, wherein the switching magnetic fields can interact with at least one second magnetic layer and control its magnetic behavior.

The invention is not restricted by the description on the basis of the exemplary embodiments. Rather, the invention encompasses any new feature and also any combination of features, which in particular comprises any combination of features in the patent claims, even if this feature or this combination itself is not explicitly specified in the patent claims or exemplary embodiments.

## Claims

1. Magnetic device, comprising
a first magnetic layer (1) and at least one second magnetic layer (2) upon each other,
wherein the first magnetic layer (1) extends along a main extension direction (99) from a first terminal region (11) to a second terminal region (12),
wherein the first terminal region (11) is designed for creating at least one domain wall (10) in the first magnetic layer (1), the domain wall (10) causing a magnetic stray field (3) that extends to the second magnetic layer (2),
wherein the at least one second magnetic layer (2) has a plurality of magnetic areas (20), each magnetic area (20) having a respective magnetization, and
wherein at least one propagation controlling element (4) controls the propagation of the at least one domain wall (10) from the first terminal region (11) to the second terminal region (12) of the first magnetic layer (1).

2. Magnetic device according to claim 1, wherein the first magnetic layer (1) comprises a soft-magnetic material.

3. Magnetic device according to claim 2, wherein the first magnetic layer (1) comprises permalloy.

4. Magnetic device according to one of the preceding claims, wherein the second magnetic layer (2) comprises a hard-magnetic material having a magnetic anisotropy.

5. Magnetic device according to claim 4, wherein the second magnetic material (2) comprises a plurality of alternatively stacked first sublayers comprising Co and second sublayers comprising Pt, Pd or Au.

6. Magnetic device according to one of the preceding claims, wherein the first magnetic layer (1) comprises at least one region which is formed as a magnetic wire (15, 15', 15") extending along the main extension direction (99).

7. Magnetic device according to claim 6, wherein the first magnetic layer (1) comprises a plurality of magnetic wires (15, 15', 15") extending along the main extension direction (99), wherein the plurality of magnetic wires (15, 15', 15") is arranged transversely to the main extension direction (99).

8. Magnetic device according to one of the preceding claims, wherein the at least one propagation controlling element (4) comprises a magnetic field generator (40) for generating a magnetic field along the main extension direction (99) of the first magnetic layer (1).

9. Magnetic device according to one of the preceding claims, wherein the at least one propagation controlling element (4) comprises a current injector for injecting an electrical current in the first magnetic layer (1).

10. Magnetic device according to one of the preceding claims, wherein the at least one propagation controlling element (4) further comprises at least one domain wall pinning element (16).

11. Magnetic device according to the preceding claim, wherein the at least one domain wall pinning element (16) comprises one or more notches in the first magnetic layer and/or one or more single domain dots arranged besides the first magnetic layer (1) and/or perpendicularly placed domain wall conductors above the first magnetic layer (1) or in a same plane as the first magnetic layer (1).

12. Magnetic device according to one of the preceding claims, wherein the at least one propagation controlling element (4) provides a non-continuous propagation of the at least one domain wall (10) in the first magnetic layer (1).

13. Magnetic device according to one of the preceding claims, wherein the magnetic device comprises a plurality of second magnetic layers (2, 2').

14. Magnetic device according to one of the preceding claims, wherein the plurality of magnetic areas (20, 21, 21', 22' 23) form at least one magnetic logic gate and/or a binary memory.
